# EUROPEAN PATENT APPLICATION

(11) **EP 1 863 085 A2**
(43) Date of publication of application: **05.12.2007**
(21) Application number: 07108980.9
(22) Date of filing: 25.05.2007
(51) Int. Cl.: H01L 23/427

(54) **Two-phase cooling system for cooling power electronic components**

(30) Priority: 01.06.2006 EP 06405245
(71) Applicant: ABB RESEARCH LTD., 8050 Zürich (CH)
(72) Inventor: Jylhakallio, Mervi, FI-02230 Espoo (FI)
(74) Representative: ABB Patent Attorneys

(57) **Abstract**

A two-phase cooling system (2) for cooling power electronic components (1) comprises a condenser section (22) and an evaporator section (21), each with at least two metal sheets (23, 23') partially bonded together, the at least two metal sheets (23, 23') forming at least one first (4) fluid channel or second fluid channel, respectively being arranged between two bonded areas of the at least two metal sheets (23, 23'). These channels form a continuous, sealed fluid channel, which connects the condenser and evaporator sections (21, 22). A power electronic element (1) can be arranged on a first main side (211) of the evaporator section (21) within a contact area (213), and the two-phase cooling system (2) can be pressed against the power electronic component (1). A support plate (5) is arranged on a second main side (212) of the evaporator section (21), the second main side (212) being opposite the first main side (211). The support plate (5) comprises at least one projecting part (51), which contacts the evaporator section (21) within the at least one bonded area or at least one support element is arranged within the at least one first fluid channel (4).

## Description

### Technical Field

The invention relates to the field of power electronics and more particularly to a two-phase cooling system for cooling power electronic components and a power electronic system according to the preamble of the independent claims.

### Background Art

DE 100 07 066 shows an arrangement for cooling electronic components. The arrangement comprises a two-phase cooling system with an evaporator part and a condenser part, in both of which channels have been formed by a roll-bonding process, the channels between both parts being connected and being partially filled with a fluid. The electronic component is arranged on the evaporator part. When heat is produced in the evaporator part by the electronic component, the fluid evaporates and expends into the condenser part. The condenser part is connected to a cooling body with cooling fins, which are air-cooled. For producing the roll-bonded channel structure thin metal sheets are used. Therefore, the structure is mechanically weak, so that not much pressure can be applied to this structure. Therefore, only electronic components with small footprint and heat flux can be cooled.

EP 1 150 086 shows a two-phase cooling system for computers with two flexible metal sheets, which are spot welded in the central portion in order to form fluid channels. Both sheets are sealingly connected on their peripheral portions. The fluid channels are partly filled with a fluid. In absence of heat the fluid channels are flat. If heat is present, the fluid can evaporate due to absorption of heat so that the fluid channels are expanded and form protruding facets. A support plate is connected to the heat producing element merely on the periphery of the cooling system for ensuring the volume-varying capability of the cooling system. DE 10 2004 007 219 shows a cooling system with a plate, which is on one side in contact with a heat producing element and on the other side with cooling fins. The plate and cooling fins have corresponding recesses, between which one end of stiff cooling pipes is arranged. The pipes are bended in a u-form and the second end of the pipes is led through through-holes in the cooling fins in an area further away from the heat producing element. In case of heat, the heat is transported through the plate to the first end of the cooling pipes and by evaporation to the second end of the cooling pipes. Then the heat is led away from the cooling fins.

### Disclosure of Invention

It is an object of the invention to provide a two-phase cooling system for cooling power electronic components, which cooling system is capable of cooling large electronic components, which produce a high amount of heat and to provide a power electronic system with such a two-phase cooling system.

This object is achieved by a semiconductor two-phase cooling system according to claim 1 and by a power electronic system according to claim 4.

The inventive two-phase cooling system comprises a condenser section and an evaporator section. The evaporator section comprises at least two metal sheets, which are partially bonded together and between two such bonded areas a first fluid channel is formed. The condenser section also comprises at least two metal sheets, which are partially bonded together and between two such bonded areas a second fluid channel is formed. Preferably, the cooling system comprises two metal sheets, each being formed integrally from one piece from the evaporator section to the condenser section.

The at least one first and second fluid channel form at least one continuous, sealed fluid channel, by which the condenser and evaporator section are fluid-conductive connected. A power electronic element can be arranged on a first main side of the evaporator section within a contact area. On the contact area of the two-phase cooling system the power electronic component can be pressed. The cooling system has at least one of the following features:
- On a second main side of the evaporator section, which second side is opposite the first main side, a support plate is arranged. The support plate comprises at least one projecting part, which contacts the evaporator section within the at least one bonded area. Or:
- At least one support element is arranged within the at least one first fluid channel.

The inventive cooling system has the advantage that the system has a high mechanical strength from all sides even if the fluid channel structure itself is mechanically weak. The at least one first fluid channel and the second fluid channel are self supporting. The form of the fluid channels is independent of the pressure inside the fluid channels and the channels are not deformed by the enhanced pressure in case of heat present. In case of no heat, the channels keep their shape, i.e. they do not collapse and the cross-section of the fluid channels is not altered by the pressure in the channels due to evaporation of the fluid. The support element or support plate strengthens the cooling system even if the first fluid channel is large or many first channels are used.

A good thermal contact can be achieved between the cooling system and a heat emitting component, because by the at least one projecting part of the support plate the cooling system can be pressed against the heat emitting component. Therefore, when the cooling system is pressed to the heat emitting component from the sides by clamps or screws as it is typically done, the cooling system cannot bend and the fluid channels cannot collapse. If the electronic component has a large surface a great amount of heat can be transmitted to the cooling system, because the channels within the cooling system can be made large without the danger of getting mechanically instable channels, because even with thin walls around the fluid channels, i.e. with thin metal sheets and large diameters of the fluid channels, the channel structure can be made mechanically stable even if the cooling system is pressed against the electronic component. In case of a support element being arranged within the at least one first fluid channel a minimum distance is achieved, so that the fluid channels cannot collapse.

### Brief Description of Drawings

The subject matter of the invention will be explained in more detail in the following text with reference to the attached drawings, in which:
- FIG 1: shows a view on a first embodiment of the power electronic system according to the invention; and
- FIG 2: shows a top view on the evaporator section on another embodiment of the power electronic system according to the invention as seen from the second main side.

The reference symbols used in the figures and their meaning are summarized in the list of reference symbols. Generally, alike or alike-functioning parts are given the same reference symbols. The described embodiments are meant as examples and shall not confine the invention.

### Modes for Carrying out the Invention

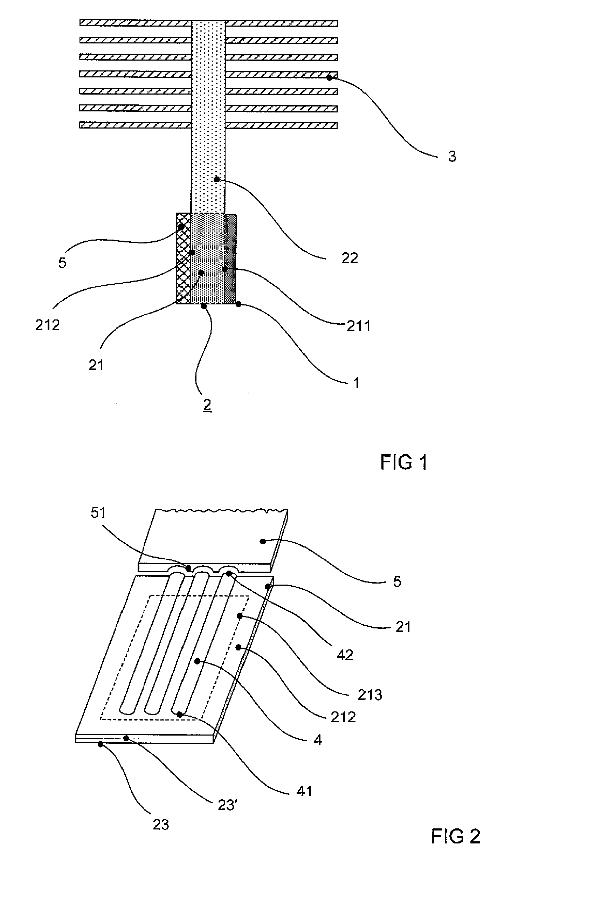

In FIG 1 a power electronic system with a two-phase cooling system 2 and a power electronic component 1 according to the invention is shown. With such a cooling system 2 power electronic components 1, which produce a high amount of heat, can be cooled. The two-phase cooling system comprises a condenser section 22 and an evaporator section 21. The evaporator section 21 comprises two metal sheets 23, 23', which are partially bonded together. A first fluid channel 4 is formed between two bonded areas of the at least two metal sheets 23, 23'. The first fluid channel is self supporting. The condenser section 22 also comprises two metal sheets, which are partially bonded together. A second fluid channel is formed between two bonded areas of the at least two metal sheets. The first fluid channel is self supporting. The at least one first 4 and second fluid channel form at least one continuous, sealed fluid channel, which connects the evaporator section 21 and the condenser section 22. The two-phase cooling system 2 is, therefore, a thermosyphon. In the at least one sealed fluid channel a fluid is filled. A power electronic component 1 is arranged on the first main side 211 of the evaporator section 21 within a contact area 213. In the evaporator section 21, a second main side 212 lies opposite the first main side 211. A support plate 5 is arranged on this second main side 212. The support plate 5 comprises at least one projecting part 51, which contacts the evaporator section 21 within the at least one bonded area and by which at least one projecting part 51 the cooling system 2 is pressed against the power electronic element 1. On the outside of the condenser section 22 cooling fins 3 are arranged.

In a preferred embodiment thermal interface material is arranged between the at least one first fluid channel 4 and the power electronic element 1, thereby improving the thermal contact and thermal heat transfer.

Heat produced in the power electronic component 1 is transferred to the two-phase cooling system 2. Within the evaporator section 21 the heat leads to latent heat of the fluid in the first fluid channels 4, so that the fluid starts to boil and vapour is produced. This vapour is transmitted through the first fluid channels 4 to the second fluid channels in the condenser section 22, the second fluid channels being directly connected to the first fluid channels 4 and forming continuous fluid channels. In the condenser section 22 the vapour is condensed, thus releasing the latent heat. This effect is exaggerated by the cooling fins 3, which are either gas-cooled, typically air-cooled, or liquid-cooled, typically water-cooled. Alternatively, it is possible to cool the second cooling channels by direct liquid cooling or a coldplate, thus without fins. The condensed fluid flows back through the same fluid channel or through another fluid channel to the evaporator section 21. Such a two-phase cooling system 2 does not need a pump for the transport of the cooling fluid away from the heat producing power electronic component. In such a two-phase cooling system the fluid is transported either by gravity force or by capillary forces.

FIG 2 shows a top view on the evaporator section 21 according to another embodiment of the inventive two-phase cooling system 2 from the second main side 212. Three single first cooling channels 4 are shown; each having a sealed end 41, but there could also be more or less first fluid channels 4 or the fluid channels could be interlinked, so that the fluid could get from one channel to the other. In any case, the fluid channel arrangement is sealed, so that no fluid can get out of these channels. On one end 42 the first fluid channels are open and connected to the second fluid channels (not shown in FIG 2). Typically, the evaporator section and condenser section 21, 22 are integrally made of one piece, i.e. of one metal sheet 23' on the second main side 212, which is a continuous sheet in the evaporator and condenser section 21, 22, and of another metal sheet 23 on the first main side 211, which is also a continuous sheet in the evaporator and condenser section 21, 22. In FIG 2 the support plate 5, which has not been mounted yet on the second main side 212 of the evaporator section 21 can be seen. The support plate 5 has projecting parts 51, which lie on the bonded areas of the metal sheet 23' after mounting. When the cooling system 2 is compressed together with the power electronic component 1, the support plate 5 only presses on the mechanically strong bonded areas of the evaporator section, thus giving a good thermal contact between the first fluid channels 4 and the power electronic component 1 without stressing the mechanically weak material in the fluid channel areas.

In a preferred embodiment the projecting parts are arranged outside an area on the second main side 212, which area lies opposite the contact area 213, which is on the first main side 211 and on which the power electronic component 1 is arranged. The contact area 213 is shown in FIG 2 by a dashed line. In that case the projecting parts 51, which do not contribute appreciably to the heat transmittal are outside the main heat path. In case that the power electronic component 1 comprises more than one semiconductor chip the projecting parts 51 of the support plate 5 can be arranged on such an area of the second main side 212, that no chip or in general, no heat generating components is arranged on the first main side 211 directly opposite of the area, on which the projecting parts 51 are arranged. This area may even be within the area opposite the contact area 213.

The at least one first fluid channel 4 can even be made as one big cavity in the contact area 213, so that the heat from the power electronic component 1 can be transmitted to the fluid over a large area. In another preferred embodiment the at least one first fluid channel 4 covers at least most of the area on the second main side 212, which lies opposite the contact area 213. This could be advantageous because of construction and mechanical reasons.

If it is feasible with the manufacturing process, at least one support element can be integrated in the first ands/or second fluid channels (not shown in a figure), so that the two-phase cooling system can be made in a very compact form. The support element in the form of a spacer is arranged within the fluid channel in such a way that a minimum distance between the at least two metal sheets (23, 23') is achieved and the fluid channel cannot collapse. The spacer can be pins or a stick between the two metal sheets 23, 23'), thin foils or plates extending their length along the length direction of the fluid channel, which foils or plates are stable enough not to be pressed together, a grid or any other spacer, which stabilizes the shape of the fluid channels. Preferably, the at least one support element is formed and arranged in such a way that the at least one first fluid channel 4 cannot be compressed by forces, which are applied in a perpendicular direction to the second main side 212.

The channel structure in the evaporator and/or the condenser section 21, 22 can be made by a roll-bonding process. Any other method, by which two metal sheets are partially bonded, leaving a channel between two bonded areas is also possible. The bonded areas could e.g. also be achieved by gluing, soldering or brazing and applying temperature and/or pressure to the sheets to be bonded. The form of the channels can be made before, during or after bonding. For forming the sheets before bonding, at least one of the sheets is coldworked in the desired shape for the channels. For forming the sheets after bonding, the channel structure is inflated after the bonding, e.g. as it is done in roll-bonding, where air is pressed into the space between two bonded areas under high pressure.

### Reference List

- 1: power electronic component
- 2: two-phase cooling system
- 21: evaporator section
- 211: first main side
- 212: second main side
- 213: contact area
- 22: condenser section
- 23, 23': metal sheet
- 3: cooling fins
- 4: first fluid channel
- 41: sealed end
- 42: open end
- 5: support plate
- 51: projecting part

## Claims

1. Two-phase cooling system (2) for cooling power electronic components (1), the cooling system (2) comprising a condenser section (22) and an evaporator section (21), the evaporator section (21) comprising at least two metal sheets (23, 23') partially bonded together, the at least two metal sheets (23, 23') forming at least one first fluid channel (4) being arranged between two bonded areas of the at least two metal sheets (23, 23')
and the condenser section (22) comprising at least two metal sheets partially bonded together, the at least two metal sheets forming at least one second fluid channel being arranged between two bonded areas of the at least two metal sheets,
the at least one first (4) and second fluid channel forming at least one continuous, sealed fluid channel, which connects the condenser and evaporator sections (21, 22), **characterized in that**
the evaporator section (21) comprises a first main side (211) with a contact area (213) for contacting a power electronic element (1), and
**in that** the two-phase cooling system (2) has at least one of the following features:
- a support plate (5) is arranged on a second main side (212) of the evaporator section (21), the second main side (212) being opposite the first main side (211), the support plate (5) comprising at least one projecting part (51), which contacts the evaporator section (21) within the at least one bonded area or
- at least one support element is arranged within the at least one first fluid channel (4).

2. Cooling system according to claim 1, **characterized in that**
in case of a support plate (5) being arranged on a second main side (212) of the evaporator section (21), the at least one projecting part (51) of the support plate (5) is arrangeable outside an area on the second main side (212), which lies opposite of the contact area (213).

3. Cooling system according to claim 1, **characterized in that**
the two-phase cooling system (2) comprises at least one spacer as support element.

4. Power electronic system with a power electronic element (1) and a cooling system (2) according to any of the preceding claims.

5. Power electronic system according to claim 4, **characterized in that**
a thermal interface material is arranged between the at least one first fluid channel (4) and the power electronic element (1).

6. Method for manufacturing a cooling system according to any of the claims 1 to 3, **characterized in that**
the at least one first (4) and/or second fluid channel is made by a roll-bonding process.
